# EUROPÄISCHE PATENTSCHRIFT

(11) **EP 0 611 737 B1**
(45) Veröffentlichungstag und Bekanntmachung des Hinweises auf die Patenterteilung: **12.05.1999**
(21) Anmeldenummer: 94102314.5
(22) Anmeldetag: 16.02.1994
(51) Int. Cl.: C04B 35/45, C04B 35/653, H01L 39/24

(54) **Verfahren zur Herstellung eines Hoch-Tc-Supraleiters als Precursormaterial für die Oxide Powder in Tube Methode (OPIT)**
Process for the production of a high-Tc superconductor precursor material for the oxide-powder-in-tube method (OPIT)
Procédé de préparation d'un matériau précurseur de supraconducteur à haute température pour la méthode "oxide-powder-in-tube" (OPIT)

(30) Priorität: 17.02.1993 DE 4304755
(43) Veröffentlichungstag der Anmeldung: 24.08.1994
(73) Patentinhaber: HOECHST AKTIENGESELLSCHAFT, 65929 Frankfurt am Main (DE)
(72) Erfinder: Neubacher, Marc, Dr., D-60529 Frankfurt (DE); Bock, Joachim, Dr., D-50374 Erftstadt (DE); Lang, Christoph, Dr., D-65929 Frankfurt (DE); Preisler, Eberhard, Dr., D-50374 Erftstadt (DE); Weis, Helga, D-65929 Frankfurt (DE)

(56) Entgegenhaltungen:
- EP-A- 0 330 214
- EP-A- 0 362 492
- EP-A- 0 524 442
- EP-A- 0 573 798
- US-A- 5 151 407
- JAP. J. APPL. PHYS. Bd. 28, Nr. 1 , Januar 1989 Seiten L37 - L40 Y. IBARA ET AL. 'Preparation and Crystallization Process of the High-Tc Superconducting Phase (Tc(end) 100 K) in Bi, Pb-Sr-Ca-Cu-O Glass-Ceramics'

## Beschreibung

In der Familie der Supraleiterkeramiken, die aus den Elementen Bismut, Strontium, Kalzium und Kupfer gebildet werden, sind im wesentlichen drei Vertreter bekannt und hinreichend untersucht worden. Dabei handelt es sich um Bi₂Sr₂Ca₂Cu₃Oₓ, bekannt als "3-Schichtverbindung", mit einer Sprungtemperatur von 110 K (H. Maeda et. al., Japan. J. Appl. Phys. 27 (1988) L209), Bi₂Sr₂Ca₁Cu₂Oₓ ("2-Schichtverbindung") mit einer Sprungtemperatur von 92 K (vgl. M. A. Subramanian et. al., Science 239 (1988) 1015) und um die Verbindung Bi₂Sr₂CuOₓ ("1-Schichtverbindung") mit einer Sprungtemperatur von 10 K (vgl. J.M. Tarascon et. al., Physica C 172 (1990) 13). Für Anwendungen oberhalb der Temperatur des flüssigen Stickstoffs kommen zum jetzigen Zeitpunkt aus dieser Strukturfamilie nur die beiden erstgenannten Verbindungen in Frage. Eine andere technisch relevante supraleitende Verbindung mit einer Sprungtemperatur oberhalb 77 K ist YBa₂Cu₃O₇₋ₓ (T_{c} = 92 K).

Die eigenliche Darstellung oxidkeramischer Supraleiter erfolgt durch eine Festkörperreaktion bei hohen Temperaturen. Die Reaktivität des für diese Reaktion eingesetzten Vorproduktes, dem sogenannten Precursor, bestimmt maßgeblich die Zeitdauer, die zur Bildung der supraleitenden Phase nötig ist. Als Faktoren, die die Reaktivität von Precursoren entscheidend beeinflussen, sind im wesentlichen die Zusammensetzung, die Homogenität, die Korngröße und die Phasenzusammensetzung des eingesetzten Pulvers zu nennen.

Setzt man vorkalzinierte Gemenge aus Metalloxiden oder anderen Verbindungen wie Carbonaten oder Nitraten etc. als Ausgangsmaterial ein (Festkörperroute), so liegen die Reaktionszeiten für die Synthese von annähernd phasenreinem 3-Schichtmaterial deutlich über 100 h (Freyhardt et al., Supercond. Sci. Technol. 3 (1990) 602).

Stellt man Precursormaterial auf naßchemischem Wege her beispielsweise durch Kopräzipitation, Gefriertrocknung oder Spraypyrolyse, so erhält man sehr homogene, reaktive Pulver. Zur Synthese dieser Materialien muß aber, im Vergleich zur Festkörperroute, nachteiligerweise ein verfahrenstechnisch aufwendigerer Weg mit einem hohen Anteil an nicht verwertbaren Nebenprodukten beschritten werden (vgl. z.B. Ward et al., Physica C 200 (1992) 31).

EP-A-0 362 492 lehrt ein Verfahren zur Herstellung eines Hochtemperatursupraleiters durch Erhitzen einer oxidischen Ausgangsmischung bis zu einer homogenen Schmelze und durch Vergießen dieser Schmelze in eine Kokille.

US-A-5,151,407 berichtet von einem Verfahren zur Herstellung eines Hochtemperatursupraleiters durch Erhitzen eines kalzinierten Gemisches auf 1200 °C. Die Schmelze wurde langsam abgekühlt und beim Erstarren der Formkörper spannungsfrei geglüht.

EP-A-0 330 214 beschreibt ein Verfahren zur Herstellung eines Hochtemperatursupraleiters durch Kalzinieren eines Ausgangsgemisches, Mahlen, axiales Pressen und Sintern, wobei die kalzinierte Mischung auch aufgeschmolzen werden kann.

Es bestand nun die Aufgabe, ein vergleichsweise einfaches Verfahren zu entwickeln, bei dem ein sehr feines, homogenes Pulver mit hoher Reaktivität resultiert, welches sich deshalb insbesondere für den Einsatz als Precursormaterial bei der OPIT-Methode eignet.

Erfindungsgemäß wird die Aufgabe gelöst durch ein Verfahren zur Herstellung eines Bismut, Strontium, Kalzium und Kupfer enthaltenden Hochtemperatursupraleiterprecursors aus einem Pulvergemenge von Metalloxiden, das zusätzlich Erdalkalimetallcarbonate enthalten kann und das die Metalle in einem Atomverhältnis enthält, das einem Supraleiter entspricht, wobei das Pulvergemenge bei Temperaturen oberhalb 1000 °C an Luft vollständig aufgeschmolzen wird, wobei dann die Schmelze auf eine Unterlage, die sich auf Raumtemperatur befindet, ausgegossen wird und wobei danach der abgekühlte Schmelzkörper zerkleinert wird, bei dem das Pulvergemenge vor dem Aufschmelzen auf Temperaturen im Bereich von 600 bis 900 °C in einer strömenden Gasatmosphäre erhitzt wird, so daß ein Pulver erhalten wird, dessen C-Gehalt kleiner 5000 ppm ist, und bei dem das Material des zerkleinerten Schmelzkörpers zu Pulver mit einer mittleren Korngröße d₅₀ ≤ 5 µm und mit einer Menge der Verunreinigung mit Eisen von deutlich unter 200 ppm zermahlen wird.

Die zu Pulver zermahlenen zerkleinerten Schmelzkörper werden dann durch Erhitzen auf Temperaturen oberhalb von 700 °C in Gegenwart von Sauerstoff zu dem fertigen Hochtemperatursupraleiter umgesetzt. Eine weitere Möglichkeit besteht darin, die grob vorzerkleinerte erstarrte Schmelze vor dem Zermahlen bei Temperaturen zwischen 600 und 900 °C in einer definierten Gasatmosphäre nachzutempern.

Durch den erfindungsgemäßen Schmelzprozeß wird eine sehr homogene Mischung der Reaktionskomponenten erhalten. Der darauffolgende Abkühlvorgang führt zu einer Masse mit einer bestimmten Phasenzusammensetzung innerhalb des Schmelzkörpers, und aus dem abschließenden Mahlprozeß resultieren sehr feine und homogene Pulver. Am Ende des Mahlprozesses liegt ein Precursorpulver mit hoher Reaktivität vor, das sich gut zu Hochtemperatursupraleitern weiterverarbeiten läßt.

Das angegebene Verfahren eignet sich besonders für Bismut enthaltende Supraleiter der Formel Bi₂(Sr,Ca)₂CuOₓ, Bi₄(Sr,Ca)₅CuOₓ, Bi₂Sr₂CaCu₂Oₓ und Bi₂Sr₂Ca₂Cu₃Oₓ. In allen Verbindungen kann Bismut bis zu 50 Mol-% durch Blei und/oder Antimon ersetzt sein. Strontium und Kalzium können partiell durch Y ersetzt werden. Auch lassen sich Vorprodukte, vor allem auch für den Einsatz bei der OPIT-Technologie, mit unterschiedlicher Zusammensetzung, beispielsweise Bi_{1,8}Pb_{0,4}Sr₂Ca_{2,2}Cu₃O₁₀₊ₓ, Bi_{1,8}Pb_{0,33}Sr_{1,93}Ca_{1,93}Cu₃O₁₀₊ₓ, Bi_{1,7}Pb_{0,4}Sr_{1,9}Ca_{2,0}Cu_{3,1}O₁₀₊ₓ oder Bi_{1,7}Pb_{0,4}Sr_{1,9}Ca_{1,0}Cu_{2,1}O₈₊ₓ, worin x einen Wert von ≤ 0,3 einnimmt, herstellen.

Sie finden Verwendung zur Herstellung von langgestreckten elektrischen Leitern nach der Oxide-Powder-In-Tube Methode.

In einem ersten Schritt werden die Erdalkalimetallcarbonate zu den Oxiden abgebaut. Dabei werden SrCO₃ und CaCO₃ mit einer Reinheit ≥ 99 % in einem Korundtiegel an Luft über einen Zeitraum von 24 h auf eine Temperatur von 1300 °C erhitzt. Daraufhin wird durch Mörsern erneut homogenisiert und abschließend nochmals für 48 h bei 1300 °C an Luft geglüht. Die Vollständigkeit der Abbaureaktion wird durch eine thermogravimetrische Messung (DTA/TG - Messung Δ Differentialthermoanalyse in Verbindung mit Thermogravimetrie) überprüft, wobei der beobachtete Massenverlust unter 1 %, vorzugsweise unter 0,1 % liegt. In einem zweiten Schritt werden die so erhaltenen Erdalkalimetalloxide mit den übrigen Metalloxiden in definiertem Verhältnis, vermengt. Hierzu werden CuO und Bi₂O₃ mit einer Reinheit ≥ 99,9 %, PbO oder PbO₂ und SrO und CaO (Reinheit ≥ 99 %) in den entsprechenden Mengen eingewogen und anschließend durch Mörsern vermengt. Das so erhaltene Gemenge wird in einem Taumler erneut homogenisiert, um eine vollständige Durchmischung zu erreichen.

In einem bevorzugten Verfahren werden SrCO₃, CaCO₃, Bi₂O₃, PbO₂ oder PbO und CuO oder Cu₂O in stöchiometrischem Verhältnis vermengt und bei Temperaturen zwischen 600 und 900°C, vorzugsweise 700 bis 800°C, unter einem fließenden Gasstrom definierter Atmosphäre erhitzt. Als Gas kann sowohl reiner Sauerstoff, synthetische Luft, vorzugsweise jedoch reiner Stickstoff verwendet werden. Der Tempervorgang kann ein- oder mehrmals unterbrochen werden, um das Pulver erneut zu vermischen, wobei die Gesamttemperzeit wenigstens 2 h, vorzugsweise wenigstens 6 h betragen soll. Es wird ein Pulver erhalten, dessen C-Gehalt kleiner 5000 ppm ist, vorzugsweise kleiner 1000 ppm.

Daraufhin wird die Oxidmischung in einen Tiegel gefüllt und anschließend in einem Muffelofen bei Temperaturen oberhalb 1000 °C, vorzugsweise oberhalb 1050 °C, geschmolzen. Um ein vollständiges Aufschmelzen des Gemenges zu erreichen, beträgt die Schmelzdauer mehr als 15 min, vorzugsweise mehr als 30 min.

Als Tiegelmaterial haben sich Magnesiumoxid, Aluminiumoxid oder Zirkonoxid bewährt, vorzugsweise wird jedoch ein Platintiegel verwendet. Eine quantitative Atomemissionsanalyse (ICP-AES-Analyse) der erstarrten Schmelze gibt den Gehalt einzelner Verunreinigungen wieder, die durch Reaktion des Tiegelmaterials mit der Schmelze entstehen. Im einzelnen wurden folgende Werte ermittelt:
- Al: > 3000 ppm
- Mg: > 500 ppm
- Pt: < 500 ppm

Der Tiegel mit der flüssigen Schmelze wird dann aus dem Ofen entnommen und ausgegossen. Dabei wird der Tiegel innerhalb des Ofens noch kurz geschwenkt, um danach unverzüglich außerhalb des Ofens entleert zu werden. Die Zeit zwischen Entnahme und Ausgießen wird dabei so kurz wie möglich gehalten und sollte vorzugsweise nicht mehr als 5 s betragen, so daß ein vorzeitiges Verfestigen von Teilen der Schmelze noch innerhalb des Tiegels nicht erfolgt. Ebenso ist es bei Verwendung eines kippbaren Schmelzofens möglich, die flüssige Schmelze ohne vorherige Entnahme des Tiegels aus dem Ofen auszugießen, so daß ein vorzeitiges Erstarren vermieden wird. Auch ist es möglich, die Schmelze mit einem motorgetriebenen Rührer, dessen Rührwerkzeug platinbeschichtet ist, vor dem Ausgießen zu rühren.

Das Ausgießen der Schmelze erfolgt erfindungsgemäß auf eine thermisch stabile Platte, vorzugsweise aus hitzebeständiger Glaskeramik, (z.B. ®Ceram, Firma Schott, Mainz) oder Kupfer, in Kupferwannen oder in Quarzrohre von unterschiedlicher Länge und unterschiedlichem Durchmesser (melt casting). Die Unterlage, auf oder in die die Schmelze gegossen wird, befindet sich auf Raumtemperatur und die Abkühlgeschwindigkeit der Schmelze liegt im Bereich zwischen 1 und 100 K/s, vorzugsweise zwischen 5 und 30 K/s. Röntgenpulveruntersuchungen so erhaltener Schmelzkörper zeigen als kristalline Anteile die 1-Schichtverbindung, Kupferoxid und Erdalkalimetallcuprate und -plumbate und aus mikroskopischen Untersuchungen lassen sich kristalline Phasenanteile von 20 bis 80 % abschätzen.

Führt man den Prozeß des Abkühlens der Schmelze sehr schnell, indem z.B. in Eiswasser gegossen wird oder zwischen zusammengepreßten Kupferplatten abgeschreckt wird, erhält man ein Material mit überwiegend amorphem Anteil (vgl. 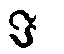 bara et al., Jap. J. Appl. Phys. 28 (1989) L37), wohingegen ein Verfahren, bei dem der Prozeß des Abkühlens mit Hilfe eines Ofens verlängert wird, zu einem Material mit überwiegend kristallinem Anteil führt.

Die erstarrten Schmelzkörper werden dann von Hand im Mörser oder mit einem Hammer, wahlweise auch maschinell mit einem Backenbrecher, grob zerschlagen. Wahlweise kann an dieser Stelle des Prozesses das grob zerkleinerte Material einer Temperbehandlung unterzogen werden. Insbesondere für das OPIT-Precursormaterial gewünschte Phasenzusammensetzungen können durch eine ein-, vorzugsweise jedoch mehrstufige Temperung bei Temperaturen zwischen 600 und 900 °C, vorzugsweise zwischen 700 und 850 °C, eingestellt werden. Dazu muß während der Temperung ein definierter Sauerstoffpartialdruck eingehalten werden. Dieser liegt zu Beginn der Temperung oberhalb 5 %, vorzugsweise oberhalb 15 %, wobei die Temperatur vorzugsweise über 800°C beträgt. In einer zweiten Stufe mit einer Temperatur vorzugsweise unterhalb 800°C liegt der Sauerstoffpartialdruck dann unterhalb von 5 %, besser unterhalb von 1 %, besonders ≤ 0,1 %. Anschließend wird das Material weiter vorzerkleinert, was in einer automatischen Mörsermühle oder einer Analysenmühle über eine Zeitspanne von wenigstens 15 min, vorzugsweise 2 bis 4 Stunden, geschehen kann. In einem abschließenden Mahlschritt wird das Material dann weiter zerkleinert bis die für die unterschiedlichen Systeme wie Planetenmühlen, Luftstrahlmühlen etc. maximal erreichbaren Feinheiten erzielt sind. Folgende Korngrößen wurden typischerweise mit Hilfe der Laserlichtstreumethode gemessen:
- Planetenmühlen: d₅₀ = 3 bis 5 µm; d₉₀ = 13 bis 15 µm
- Luftstrahlmühlen: d₅₀ = 1 bis 4 µm; d₉₀ = 2 bis 6 µm

Bei den Zerkleinerungs- und Mahlschritten kommt es durch die auftretenden Mahlkräfte zum Abrieb an den Mahlkörpern. Dies führt zu Verunreinigungen des betreffenden Mahlgutes. So wurden bei Planetenmühlen mit Mahlkörpern aus ZrO₂ weniger als 50 ppm Zr im Mahlgut gefunden. In Luftstrahlmühlen kann durch eine Beschichtung der Stahlteile mit Wolframcarbid die Menge der Verunreinigung mit Eisen von weit über 500 ppm auf deutlich unter 200 ppm gesenkt werden.

In den nachfolgenden Ausführungsbeispielen wird die Erfindung für den Fachmann noch deutlicher dargestellt, ohne jedoch auf die konkret dargestellten Ausführungsformen beschränkt zu sein.

### Beispiel 1

Ein Ansatz der Zusammensetzung Bi_{1,8}Pb_{0,4}Sr₂Ca_{2,2}Cu₃O_{10,3} wurde in einem Platintiegel bei einer Temperatur von 1080 °C an Luft über eine Zeit von 1 h in einem Muffelofen geschmolzen und in eine Cu-Wanne mit einem Volumen von 500 ml gegossen. Die so erhaltenen Schmelzblöcke wurden in einem Backenbrecher und in einer Analysenmühle vorzerkleinert und danach in einer mit Wolframcarbid ausgekleideten Luftstrahlmühle zu einem Pulver zermahlen. Das so erhaltene Pulver ist wie folgt charakterisiert:
a. Die Zusammensetzung nach ICP-AES Analyse beträgt: Bi_{1,83}Pb_{0,40}Sr_{2,0}Ca_{2,09}Cu₃Oₓ mit x ≤ 10,3.
b. Verunreinigungen durch Tiegelmaterial und Mahlkörper: Fe = 70 ppm ; Pt = 450 ppm
c. Die mittlere Korngröße d₅₀ beträgt 2,8 µm bestimmt durch Laserlichtbeugung.
d. Röntgenpulveraufnahmen zeigen neben 50 % amorphem Anteil weitere 50 % an kristalliner Phase, die sich wie folgt zusammensetzt:
   * 60 % 1-Schichtverbindung,
   * 25 % Erdalkalimetallcuprate,
   * 5 % Erdalkaliplumbate und
   * 10 % Kupferoxid.
e. Lichtmikroskopische Schliffaufnahmen zeigen einen amorphen Anteil von 50%.
f. REM-Aufnahmen zeigen gleichmäßige, homogene Körner.

### Beispiel 2

Bi₂O₃, PbO₂, SrCO₃, CaCO₃ und CuO wurden im Verhältnis Bi_{1,7}Pb_{0,4}Sr_{1,9}Ca_{2,0}Cu_{3,1}O₁₀₊ₓ eingewogen vermengt und anschließend bei 750°C unter fließendem Stickstoff 12 h erhitzt. Danach wurde erneut gemischt und unter gleichen Bedingungen weitere 40 h getempert. Das so erhaltene Material wurde in einem Pt-Tiegel bei 1150°C an Luft über eine Zeit von 30 min erschmolzen und anschließend auf eine Cu-Platte gegossen. Die grob vorzerkleinerten Schmelzbrocken wurden anschließend für 12 h bei 820°C in einer strömenden Gasatmosphäre (100 l/h, N₂:O₂ = 80:20) und für weitere 12 h bei 780°C ebenfalls in einer strömenden Gasatmosphäre (100l/h, N₂:O₂ = 99,9:0,1) erhitzt. Das so erhaltene Material wird weiter vorzerkleinert und anschließend in einer mit Wolframcarbid ausgekleideten Luftstrahlmühle gemahlen.

Das so erhaltene Pulver ist wie folgt charakterisiert:
a) Verunreinigungen durch Tiegelmaterial und Mahlkörper
   - Fe: < 50 ppm
   - Pt: = 400 ppm
b) die mittlere Korngröße d₅₀ beträgt 2,6 µm, bestimmt durch Laserlichtbeugung
c) aus Röntgenpulveruntersuchungen läßt sich folgende Phasenzusammensetzung ablesen:
   - 80 % 2-Schichtverbindung
   - 15 % Erdalkalimetallcuprate
   - 5 % CuO

## Patentansprüche

1. Verfahren zur Herstellung eines Bismut, Strontium, Kalzium und Kupfer enthaltenden Hochtemperatursupraleiterprecursors aus einem Pulvergemenge von Metalloxiden, das zusätzlich Erdalkalimetallcarbonate enthalten kann und das die Metalle in einem Atomverhältnis enthält, das einem Supraleiter entspricht, wobei das Pulvergemenge bei Temperaturen oberhalb 1000 °C an Luft vollständig aufgeschmolzen wird, wobei dann die Schmelze auf eine Unterlage, die sich auf Raumtemperatur befindet, ausgegossen wird und wobei danach der abgekühlte Schmelzkörper zerkleinert wird, dadurch gekennzeichnet, daß das Pulvergemenge vor dem Aufschmelzen auf Temperaturen im Bereich von 600 bis 900 °C in einer strömenden Gasatmosphäre erhitzt wird, so daß ein Pulver erhalten wird, dessen C-Gehalt kleiner 5000 ppm ist, und daß das Material des zerkleinerten Schmelzkörpers zu Pulver mit einer mittleren Korngröße d₅₀ ≤ 5 µm und mit einer Menge der Verunreinigung mit Eisen von deutlich unter 200 ppm zermahlen wird.

2. Verfahren nach Anspruch 1, dadurch gekennzeichnet, daß Supraleiter der Formel Bi₂(Sr,Ca)₂CuO₆, Bi₄(Sr,Ca)₅CuO₁₂, Bi₂Sr₂CaCu₂O₈ und Bi₂Sr₂Ca₂Cu₃O₁₀ eingesetzt werden, wobei Bismut bis zu einer Menge von 50 Mol-% durch Blei und/oder Antimon ersetzt sein kann und wobei Strontium und Kalzium in einer Menge von 0 bis 30 Mol-% durch Yttrium ersetzt sein kann.

3. Verfahren nach Anspruch 1 oder 2, dadurch gekennzeichnet, daß das Gemenge vor dem Aufschmelzen in einen Tiegel, der vorzugsweise aus Platin besteht, gefüllt und anschließend in einem Ofen bei Temperaturen oberhalb 1050 °C aufgeschmolzen wird.

4. Verfahren nach einem der Ansprüche 1 bis 3, dadurch gekennzeichnet, daß die Schmelzdauer mehr als 15 min, vorzugsweise mehr als 30 min, beträgt.

5. Verfahren nach einem der Ansprüche 1 bis 4, dadurch gekennzeichnet, daß das Ausgießen der Schmelze auf eine thermisch stabile Platte, insbesondere aus Keramik oder Metall, vorzugsweise aus Kupfer, erfolgt und daß die Abkühlgeschwindigkeit der Schmelze im Bereich von 1 bis 100 K/s, vorzugsweise 5 bis 30 K/s liegt.

6. Verfahren nach einem der Ansprüche 1 bis 5, dadurch gekennzeichnet, daß der erstarrte Schmelzkörper im Mörser oder mit einem Hammer grob zerschlagen und anschließend weiter vorzerkleinert wird und daß das Material dann weiter zerkleinert wird bis eine Korngröße im Bereich von d₅₀ ≤ 5 µm, vorzugsweise d₅₀ ≤ 3 µm, erreicht ist.

7. Verfahren nach einem der Ansprüche 1 bis 6, dadurch gekennzeichnet, daß die grob zerkleinerte erstarrte Schmelze unter definiertem Sauerstoffpartialdruck bei Temperaturen zwischen 600 und 900 °C erhitzt und anschließend weiter zerkleinert wird.

8. Precursor für einen Bi-2223-Hochtemperatursupraleiter hergestellt nach einem Verfahren nach einem der Ansprüche 1 bis 7, dadurch gekennzeichnet, daß er eine Zusammensetzung entsprechend der Formel Bi_{1,8}Pb_{0,4}Sr₂Ca_{2,2}Cu₃O₁₀₊ₓ, Bi_{1,8}Pb_{0,33}Sr_{1,93}Ca_{1,93}Cu₃O₁₀₊ₓ, Bi_{1,7}Pb_{0,4}Sr_{1,9}Ca_{2,0}Cu_{3,1}O₁₀₊ₓ oder Bi_{1,7}Pb_{0,4}Sr_{1,9}Ca_{1,0}Cu_{2,1}O₈₊ₓ besitzt, worin x einen Wert von ≤ 0,3 einnimmt.

9. Verwendung von Precursoren nach Anspruch 8 zur Herstellung von langgestreckten elektrischen Leitern nach der Oxide-Powder-In-Tube-Methode.

## Claims

1. A process for preparing a high-temperature superconductor precursor containing bismuth, strontium, calcium and copper from a powder mixture of metal oxides which may additionally contain alkaline earth metal carbonates and contains the metals in an atomic ratio corresponding to a superconductor, where the powder mixture is completely melted in air at temperatures above 1000°C, the melt is then poured out onto a base which is at room temperature, and the cooled melt body is subsequently crushed, wherein the powder mixture is, prior to melting, heated to temperatures in the range of from 600 to 900°C in a flowing gas atmosphere so that a powder whose C content is less than 5000 ppm is obtained, and the material of the crushed melt body is ground to powder having a mean grain size d₅₀ ≤ 5 µm and containing an amount of iron contamination of significantly less than 200 ppm.

2. The process as claimed in claim 1, wherein superconductors of the formula Bi₂(Sr,Ca)₂CuO₆, Bi₄(Sr,Ca)₅CuO₁₂, Bi₂Sr₂CaCu₂O₈ and Bi₂Sr₂Ca₂Cu₃O₁₀ are employed, in which bismuth can be replaced, up to an amount of 50 mol%, by lead and/or antimony, and in which strontium and calcium can be replaced, in an amount of from 0 to 30 mol%, by yttrium.

3. The process as claimed in claim 1 or 2, wherein the mixture, prior to melting, is filled into a crucible, which preferably is composed of platinum, and is then melted in a furnace at temperatures above 1050°C.

4. The process as claimed in any one of claims 1 to 3, wherein the duration of melting is more than 15 min, preferably more than 30 min.

5. The process as claimed in any one of claims 1 to 4, wherein the melt is poured out onto a thermally stable plate, especially composed of ceramic or metal, preferably of copper, and wherein the cooling rate of the melt is in the range of from 1 to 100 K/s, preferably from 5 to 30 K/s.

6. The process as claimed in any one of claims 1 to 5, wherein the solidified melt body is broken up coarsely in a mortar or with a hammer and is then subjected to further coarse crushing, and wherein the material is then further reduced in size until a grain size in the range of d₅₀ ≤ 5 µm, preferably d₅₀ ≤ 3 µm, is attained.

7. The process as claimed in any one of claims 1 to 6, wherein the coarsely broken solidified melt is heated under a defined oxygen partial pressure at temperatures between 600 and 900°C and is then further reduced in size.

8. A precursor for a Bi-2223 high-temperature superconductor, prepared according to a process as claimed in any one of claims 1 to 7, wherein the precursor has a composition corresponding to the formula Bi_{1.8}Pb_{0.4}Sr₂Ca_{2.2}Cu₃O₁₀₊ₓ, Bi_{1.8}Pb_{0.33}Sr_{1.93}Ca_{1.93}Cu₃O₁₀₊ₓ, Bi_{1.7}Pb_{0.4}Sr_{1.9}Ca_{2.0}Cu_{3.1}O₁₀₊ₓ or Bi_{1.7}Pb_{0.4}Sr_{1.9}Ca_{1.0}Cu_{2.1}O₈₊ₓ, in which x adopts a value of ≤ 0.3.

9. The use of precursors as claimed in claim 8 for preparing elongated electrical conductors according to the oxide-powder-in-tube method.

## Revendications

1. Procédé de préparation d'un précurseur de supraconducteur haute température contenant du bismuth, du strontium, du calcium et du cuivre à partir d'un mélange de poudres d'oxydes métalliques, qui peut de plus contenir des carbonates de métaux alcalino-terreux, et qui contient les métaux dans un rapport atomique qui correspond à un supraconducteur, dans lequel le mélange de poudres est complètement fondu à l'air à des températures au-dessus de 1000°C, dans lequel la fonte est ensuite coulée sur un support qui se trouve à température ambiante et dans lequel la matière fondue refroidie est concassée, caractérisé en ce que, le mélange de poudres est chauffé avant la fusion à des températures dans l'intervalle de 600 à 900°C dans l'atmosphère d'un gaz circulant, de manière à obtenir une poudre dont la teneur en carbone soit inférieure à 5000 ppm, et en ce que le matériau du solide de fusion concassé est broyé en poudre avec une taille moyenne de grains d₅₀ ≤ 5 µm et avec une teneur en impureté de fer significativement inférieure à 200 ppm.

2. Procédé selon la revendication 1, caractérisé en ce qu'on utilise des supraconducteurs de formule Bi₂(Sr,Ca)₂CuO₆, Bi₄(Sr,Ca)₅CuO₁₂, Bi₂Sr₂CaCu₂O₈ et Bi₂Sr₂Ca₂Cu₃O₁₀, dans lesquelles on peut remplacer le bismuth jusqu'à une quantité de 50% en mole par du plomb et/ou de l'antimoine et dans lesquelles on peut remplacer le strontium et le calcium en une quantité de 0 jusqu'à 30% en mole par de l'yttrium.

3. Procédé selon la revendication 1 ou 2, caractérisé en ce qu'on charge le mélange avant la fusion dans un creuset, qui est de préférence constitué de platine, et qu'on le fond ensuite dans un four à des températures au-dessus de 1050°C.

4. Procédé selon l'une des revendications 1 à 3, caractérisé en ce que la durée de la fusion est de plus de 15 min., de préférence de plus de 30 min.

5. Procédé selon l'une des revendications 1 à 4, caractérisé en ce que la coulée de la fonte est effectuée sur une plaque stable thermiquement, en particulier en céramique ou en métal, de préférence en cuivre et en ce que la vitesse de refroidissement de la fonte se situe dans l'intervalle de 1 à 100 K/s, de préférence de 5 à 30 K/s.

6. Procédé selon l'une des revendications 1 à 5, caractérisé en ce que la matière de fusion solidifiée est concassée grossièrement au mortier ou avec un marteau et ensuite encore broyée, et en ce qu'on continue ensuite le broyage du matériau jusqu'à ce qu'on atteigne une taille de grains dans le domaine d₅₀ ≤ 5 µm, de préférence d₅₀ ≤ 3 µm.

7. Procédé selon l'une des revendications 1 à 6, caractérisé en ce qu'on chauffe la matière de fusion solidifiée, grossièrement concassée, sous une pression partielle d'oxygène définie à des températures entre 600 et 900°C et qu'ensuite on continue le concassage.

8. Précurseur pour un supraconducteur à haute température Bi-2223 préparé par un procédé selon l'une des revendications 1 à 7, caractérisé en ce qu'il possède une composition correspondant à la formule Bi_{1,8}Pb_{0,4}Sr₂Ca_{2,2}Cu₃O₁₀₊ₓ, Bi_{1,8}Pb_{0,33}Sr_{1,93}Ca_{1,93}Cu₃O₁₀₊ₓ, Bi_{1,7}Pb_{0,4}Sr_{1,9}Ca_{2,0}Cu_{3,1}O₁₀₊ₓ ou Bi_{1,7}Pb_{0,4}Sr_{1,9}Ca_{1,0}Cu_{2,1}O₈₊ₓ, dans lesquelles x représente une valeur ≤ 0,3.

9. Utilisation de précurseurs selon la revendication 8 pour la préparation de conducteurs électriques étirés en longueur selon le procédé oxide-powder-in-tube.
